# EUROPEAN PATENT APPLICATION

(11) **EP 2 075 993 A1**
(43) Date of publication of application: **01.07.2009**
(21) Application number: 08773073.5
(22) Date of filing: 01.07.2008
(51) Int. Cl.: H04M 1/02

(54) **A MOBILE TERMINAL PREVENTING TEMPERATURE RISING OF USER-SENSITIVE SURFACE**

(30) Priority: 02.07.2007 CN 200720155430 U; 20.09.2007 CN 200720173250 U
(71) Applicant: Huawei Technologies Co., Ltd., Longgang District, Shenzhen Guangdong 518129 (CN)
(72) Inventor: JIN, Linfang, Shenzhen, Guangdong 518129 (CN); WEI, Dong, Shenzhen, Guangdong 518129 (CN); WU, Guzheng, Shenzhen, Guangdong 518129 (CN)
(74) Representative: Körber, Martin Hans
(86) International application number: PCT/CN2008/071511
(87) International publication number: WO 2009/003411

(57) **Abstract**

A mobile terminal for preventing temperature increase of a user-sensitive surface, a display device, and a heat dissipating device for an electronic product based upon user satisfaction are provided. The mobile terminal for preventing temperature increase of a user-sensitive surface includes a user-sensitive surface and a printed circuit board (PCB), in which a heat-insulation layer is located between the user-sensitive surface and the PCB. The display device includes a display screen. A housing having a vacuum space is set on a back side of the display screen. Through the above technical solutions, the temperature of the user-sensitive surface is effectively controlled in usage, the user satisfaction is effectively increased, and the probability of complaints about heating is effectively lowered. The heat dissipating device for an electronic product based upon user satisfaction includes a thermal-conductive housing set surrounding a PCB and heat-generating components. A user contact area on the thermal-conductive housing is set with heat-insulation structures adapted to reduce the surface temperature of the area. In the embodiments of the present invention, through the heat-insulation structures set on the user contact area of the thermal-conductive housing and adapted to reduce the surface temperature of the area, a user's feeling about an excessively high surface temperature caused by heat transfer when he/she touches the electronic product with the heat dissipating device as a housing or a portion of the housing is alleviated. Meanwhile, the thermal-conductive housing inside the heat-insulation structures can serve as a heat dissipating device to effectively control the temperature increase of the heat-generating components and non-uniform surface temperature of the products.

## Description

### FIELD OF THE TECHNOLOGY

The present invention relates to a mobile terminal, and more particularly to a mobile terminal for preventing temperature increase of a user-sensitive surface and a heat dissipating device for an electronic product based upon user satisfaction.

### BACKGROUND

With the development of wireless communication and chip packaging technologies, more and more functions have been integrated into cell phones. Accordingly, the power consumption of the cell phone tends to become even higher and thus more and more heat is generated when making or receiving a phone call via the cell phone. During the process of implementing the present invention, it is found by the inventor(s) that the Power Amplifier (PA) component is the main heat source, which generally takes 40-60% of the overall heat consumption of the cell phone. For a 3-generation cell phone adopting Code Division Multiple Access (CDMA) technology, the heat consumption of the PA at a large transmission power is increased for at least 50% as compared with a Global System for Mobile Communications (GSM) cell phone, and the temperature of the housing thereof reaches up to 30-50□. Heating components such as PA in the cell phone are usually located below a user-sensitive surface. The user-sensitive surface is a surface portion of the cell phone that contacts with the user's ear and face when the cell phone is used, i.e., the earpiece of the cell phone or a portion adjacent to the earpiece of the cell phone that is close to or contacts with the user's ear and face when the cell phone is used. A large amount of heat generated by the heating components such as PA in usage causes an increase of the temperature of the user-sensitive surface, which thus makes the user feel uncomfortable, thereby affecting the user experience.

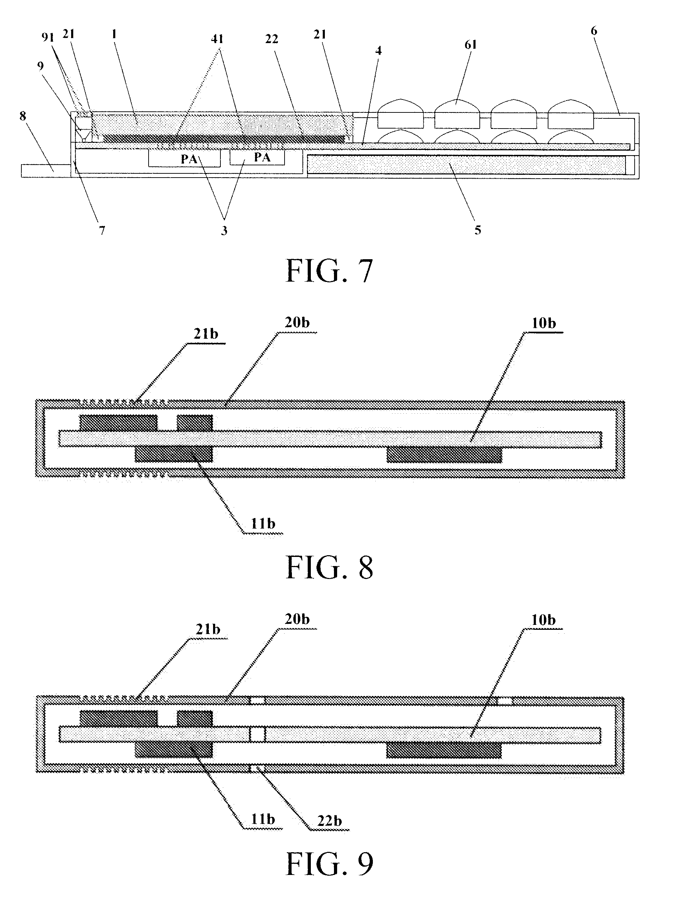

Taking a bar phone as an example, the PAs are generally located below a Liquid Crystal panel (LCD) of the bar phone. Referring to FIG. 7, 22 indicates thin foamed plastic, 5 indicates a battery, 6 indicates an upper cover of the housing, 61 indicates keys, 7 indicates a lower cover of the housing, and 9 indicates a loudspeaker. A Radio-Frequency (RF) circuit is set on a lower surface of a Printed Circuit Board (PCB) 4 below an LCD 1, which is close to an antenna 8 and guarantees the RF performance. The PAs 3 in the RF circuit are correspondingly located below the LCD 1. As such, the heat generated during the working process of the PAs 3 is transferred through a space supported by brackets 21 via thermal vias 41 on the PCB 4, so that a large amount of heat is guided to the LCD 1, and as a result, the temperature of the LCD 1 is raised rapidly in a short time. Since the LCD 1 is close to a headset 91 of the cell phone and belongs to a user-sensitive surface of the cell phone, the user feels uncomfortable. Similar problem occurs to other types of cell phones such as flip phones and slider phones, when the heating elements of the cell phones are close to the headsets of the cell phones.

Currently, in order to solve the problem of the excessive high temperature of the user-sensitive surface of the cell phone, two technical solutions are adopted. One solution is to reduce the heat transfer from the heating components to the user-sensitive surface by means of enlarging the volume of the cell phone and the heat-dissipation area of the heating components, so as to reduce the temperature of the user-sensitive surface, thereby preventing the user from being affected by an excessive high temperature of the user-sensitive surface. The other solution is to increase a thermal resistance by means of increasing the distance between the user-sensitive surface and the PCB, thereby reducing the temperature of the user-sensitive surface. However, the technical solutions through enlarging the volume of the cell phone and increasing the distance between the LCD and the PCB not only affect the appearance of the cell phone, but also make the cell phone to become excessively large in volume, which is not convenient to carry along and does not accord with the current miniaturizing trend of the cell phone.

As for designs of electronic products, especially consumer electronic products such as cell phones, Personal Digital Assistants (PDAs), USB sticks, USB modem sticks, multimedia conference terminals and set-top boxes, the smaller, the better. Small consumer electronic products are mainly confronted with challenges from Industrial Design (ID)/Mechanical Design (MD) and overall design requirements of the products, that is, having appealing appearances, smaller volumes, and powerful functions.

With the development of electronics and chip packaging technologies, the miniaturization trend of the electronic products has been well achieved, and meanwhile, the electronic products have more powerful functions. However, since the packaging density is continuously increased, heat-flow density of the electronic products is rapidly increased accordingly. Therefore, thermal designs must be employed in the electronic products to reduce the effect of the temperature on the reliability of the electronic products, so as to enable the electronic products to work within a wide temperature range. Since the miniaturization design of the electronic products results in a limited inner space, most of the thermal design technologies through using fans, heat sinks, or heat pipes cannot be employed. Generally, thermal designs of the consumer communication electronic products must meet the following basic requirements: the temperatures of heating components should not exceed permitted levels, so as to meet the requirements for the reliability of the heating components; and the surface temperatures of the products should be as low as possible, so as to avoid users' complaints.

Currently, most manufacturers produce the consumer electronic products using plastic housings, in order to save the cost. However, the thermal conductivity coefficient of a common plastic is about 0.4 W/m·K and the differences between the product surface temperatures may exceed 10□, which cannot meet the requirements of future development. As seen from thermal simulation and actual testing of a product using a plastic housing with a high thermal conductivity coefficient (0.7W/m·K), the maximum surface temperature increase is merely reduced by less than 12□. Since the cost thereof is greatly increased, it is not widely used at present.

Moreover, currently, there is another type of electronic products with metal housings. The metal housings thereof are made of magnesium alloy, aluminum alloy, stainless steel or others. With the same structure and power consumption, the simulation and testing results show that the maximum surface temperature increase is reduced by up to 5-15□. However, it is difficult or costs a lot for the metal housings to meet the complex profile design requirements. Moreover, since the thermal conductivity coefficient of metal is significantly higher than that of plastics, under the same temperature, the metal is more liable to make the user feel warm or even hot upon being touched, thereby reducing the user satisfaction and resulting in the user's complaints. Therefore, currently, the metal housings are mainly applicable to products with a low heat-flow density or industrial products such as micro base stations that are not often touched by users.

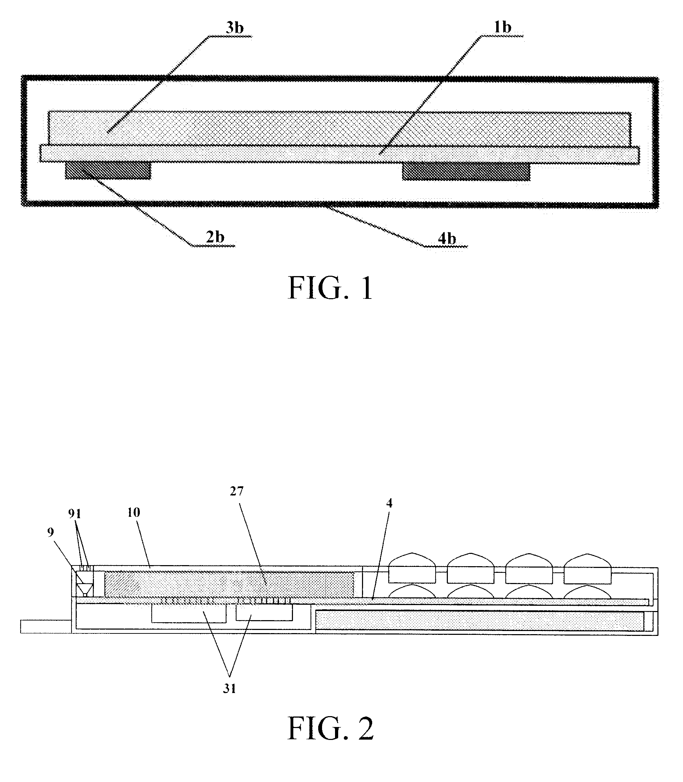

FIG. 1 is a schematic view of an internal structure of an electronic product in the prior art. Referring to FIG. 1, the electronic product includes a PCB 1b set in a plastic housing 4b. Heating components 2b are located on the PCB 1b. A metal housing 3b is fastened on the PCB 1b. Through the metal housing for temperature equalization and electromagnetic shielding set within the electronic product, temperatures of the heating components are maintained within a permitted range, thereby meeting the requirements for reliability of the heating components, without affecting the complex profile design requirements for the product. However, since the above metal housing particularly emphasizes on meeting the requirements for the reliability of the heating components, the effect on controlling the product surface temperature is relatively poor. Especially when some heating components are not covered by the metal housing and close to the plastic housing, a local high-temperature region is formed. In addition, if the thermal resistance of the above electronic product is analyzed, by means of comparing the thermal resistances of the heating components, the housing, and the external environment, it is found that the maximum thermal resistance and heat dissipation bottleneck are between the surface of the housing and the external environment. The built-in metal housing cannot enhance the heat transfer capability between the product and the external environment.

### SUMMARY

Accordingly, the present invention is directed to a mobile terminal for preventing temperature increase of a user-sensitive surface and a display device, so as to solve the problems in the prior art, and to control the temperature of the user-sensitive surface in usage.

The present invention is also directed to a heat dissipating device for an electronic product based upon user satisfaction, which is adapted to solve the problem about an excessive high surface temperature of the electronic product in usage.

According to the first embodiment of the present invention, a mobile terminal for preventing temperature increase of a user-sensitive surface is provided, which includes a user-sensitive surface and a printed circuit board (PCB). A heat-insulation layer is set between the user-sensitive surface and the PCB.

According to the first embodiment of the present invention, a display device is also provided, which includes a display screen. A heat-insulation housing is set on a back side of the display screen.

In the above technical solution of the mobile terminal, a heat-insulation layer is set between the user-sensitive surface and the PCB to effectively control the temperature of the user-sensitive surface in usage. In the above technical solution of the display device, a heat-insulation housing is set on a back side of the display to effectively control the temperature of the display in usage when the display serves as the user-sensitive surface, thereby achieving the purpose of controlling the temperature of the user-sensitive surface.

According to the second embodiment of the present invention, the following technical solution is provided. A heat dissipating device for an electronic product based upon user satisfaction is provided, which includes: a thermal-conductive housing, surrounding a PCB and heat-generating components. A user contact area on the thermal-conductive housing is set with heat-insulation structures adapted to reduce the surface temperature of the area.

In the embodiment of the present invention, through disposing the heat-insulation structures adapted to reduce the surface temperature on the user contact area of the thermal-conductive housing, a user's feeling about an excessively high surface temperature caused by heat dissipation when he/she touches the electronic product with the heat dissipating device as a housing or a portion of the housing is alleviated.

The technical solutions of the present invention are described below in further detail through the accompanying drawings and embodiments.

### BRIEF DESCRIPTION OF THE DRAWINGS

The present invention will become more fully understood from the detailed description given herein below for illustration only, and thus is not limitative of the present invention.

FIG. 1 is a schematic view of an internal structure of an electronic product in the prior art;

FIG. 2 is a schematic structural view of the first embodiment of a mobile terminal for preventing temperature increase of a user-sensitive surface according to the present invention;

FIG. 3 is a schematic structural view of the second embodiment of a mobile terminal for preventing temperature increase of a user-sensitive surface according to the present invention;

FIG. 4 is a schematic structural view of the third embodiment of a mobile terminal for preventing temperature increase of a user-sensitive surface according to the present invention;

FIG. 5 is a schematic structural view of the first embodiment of a display device according to the present invention;

FIG. 6 is a schematic structural view of the second embodiment of a display device according to the present invention;

FIG. 7 is a schematic structural view of a cell phone in the prior art;

FIG. 8 is a schematic structural view of the first embodiment of a heat dissipating device for an electronic product according to the present invention;

FIG. 9 is a schematic structural view of a second embodiment of a heat dissipating device for an electronic product according to the present invention;

FIG. 10 is a schematic structural view of a third embodiment of a heat dissipating device for an electronic product according to the present invention;

FIG. 11 is a schematic structural view of a fourth embodiment of a heat dissipating device for an electronic product according to the present invention;

FIG. 12 is a schematic structural view of a fifth embodiment of a heat dissipating device for an electronic product according to the present invention;

FIG. 13 is a schematic structural view of a sixth embodiment of a heat dissipating device for an electronic product according to the present invention;

FIG. 14 is a schematic structural view of a seventh embodiment of a heat dissipating device for an electronic product according to the present invention; and

FIG. 15 is a schematic view of an application example of a heat dissipating device for an electronic product according to the present invention.

### DETAILED DESCRIPTION

A mobile terminal described in the present invention includes a cell phone, a personal digital assistant (PDA), and the like. Embodiments of the present invention are described below by taking the cell phone as an example.

Embodiment 1 of Cell Phone

FIG. 2 is a schematic structural view of a first embodiment of a mobile terminal for preventing temperature increase of a user-sensitive surface according to the present invention. Referring to FIG. 2, an enclosed space 27 is set between a user-sensitive surface 10 and a PCB 4. The enclosed space 27 is turned into a vacuum state by means of vacuum pumping with a vacuum pump. Since the thermal conductivity coefficient of the vacuum is basically 0 and no convection heat transfer occurs in the vacuum, the heat of heating components 31 such as PAs is effectively prevented from being conducted to the user-sensitive surface 10 via the enclosed space 27, thereby greatly reducing the temperature of the user-sensitive surface.

Embodiment 2 of Cell Phone

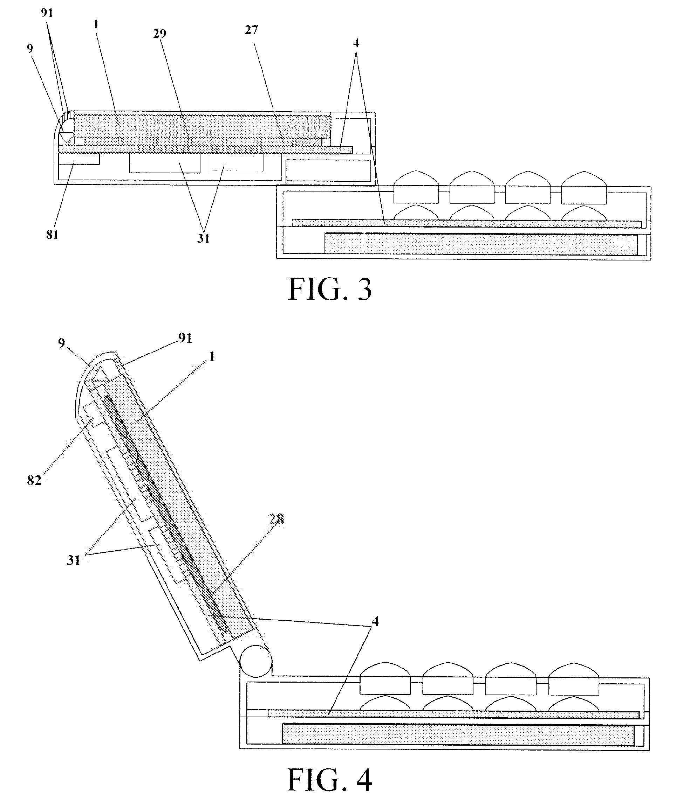

FIG. 3 is a schematic structural view of a second embodiment of a mobile terminal for preventing temperature increase of a user-sensitive surface according to the present invention. Referring to FIG. 3, a user-sensitive surface of a slide phone is an LCD screen 1. An antenna 81 is built in an upper cover. Heating components 31 such as PAs, are set below the LCD screen 1. A space 27 between the LCD screen 1 and a corresponding PCB 4 there below is in a vacuum state. In the enclosed space 27 in the vacuum state, supports 29 are further set between the LCD screen 1 and the PCB 4 for providing a supporting function, so as to guarantee the structural strength between the LCD screen 1 and the PCB 4.

Embodiment 3 of Cell Phone

FIG. 4 is a schematic structural view of a third embodiment of a mobile terminal for preventing temperature increase of a user-sensitive surface according to the present invention. Referring to FIG. 4, a user-sensitive surface of a flip phone is an LCD screen 1 on an upper cover. An antenna 82 is built in the upper cover. Vacuum fibers 28 or foamed plastics are filled between the LCD screen 1 and a corresponding PCB 4, so that a portion of the space between the LCD screen 1 and the PCB 4 is in a vacuum state and the other portion is filled with air, thereby greatly reducing the thermalconductivity coefficient between the LCD screen 1 and the PCB 4. Meanwhile, the amount of air between the LCD screen 1 and the PCB 4 is reduced, which also effectively reduces the convection heat transfer, thereby effectively preventing the heat of the heating components such as PAs from being transferred to the LCD screen 1.

In the above embodiments of cell phones, surfaces surrounding the space between the user-sensitive surface and the PCB may be coated with a metal such as silver. With smooth surfaces of the metal such as silver, the heat transfer caused by heat radiation is effectively reduced. Thus, the thermal resistance between the external environment and the user-sensitive surface is increased and the heat transfer caused by heat radiation is reduced. Therefore, the heat of the heating components such as PAs is further prevented from being transferred to the user-sensitive surface.

In the above embodiments, a distance between the user-sensitive surface and the PCB is 0.5 mm-3.0 mm. Since a desirable heat-insulation effect is achieved through the above embodiments, the distance between the user-sensitive surface and the PCB can be shortened to 0.5 mm. In such a manner, the cell phone is greatly reduced in volume and thus becomes convenient to carry along, thereby greatly enhancing the commercial competition power.

It should be noted that, the user-sensitive surface refers to a surface portion of a mobile terminal such as a cell phone and a PDA that contacts with a user's ear and face when being used, which is not limited to the LCD screen mentioned in the above embodiments. As long as a user-sensitive surface of a mobile terminal such as a cell phone and a PDA is set above the heating components such as PAs, the structure between the user-sensitive surface and the PCB can adopt the technical solutions given in the above embodiments. Moreover, the structure between the user-sensitive surface and the PCB in the above embodiments is not only applicable to double-mode cell phones with two PAs, such as GSM/WCDMA and GSM/CDMA, but also applicable to single-mode cell phones with only one PA, such as GSM, CDMA, and WCDMA, which will not be described herein again.

Embodiment 1 of Display Device

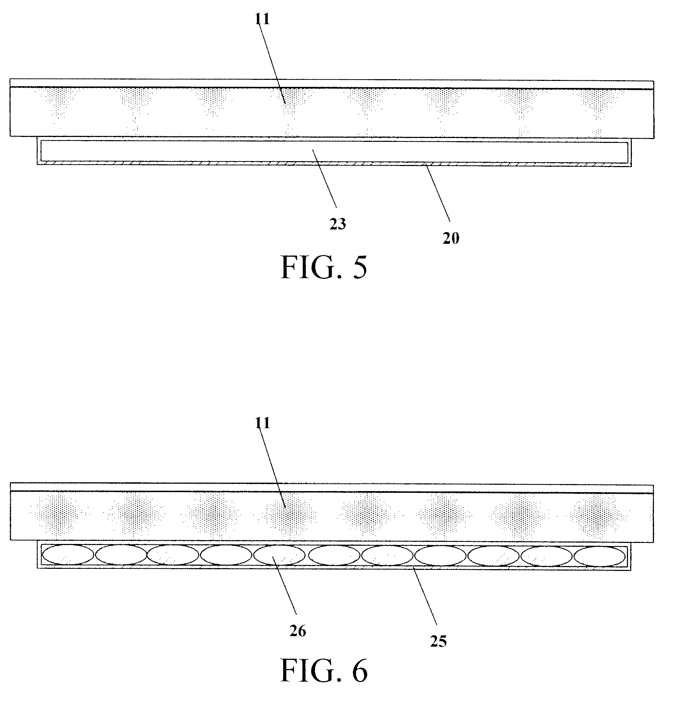

FIG. 5 is a schematic structural view of a first embodiment of a display device according to the present invention. Referring to FIG. 5, the device includes a display screen 11 and a housing 20. The housing 20 is set on a back side of the display screen 11. Surfaces of the housing 20 are connected with each other in a sealing manner, so that the housing 20 is formed with an internal enclosed space 23. The enclosed space 23 is in a vacuum state. Since the thermal conductivity coefficient of the vacuum is basically 0 and no convection heat transfer occurs in the vacuum, the external heat is effectively prevented from being conducted to the display screen via the housing 20.

In this embodiment, through disposing a vacuum body on the back side of the display screen, the problem of a rapid temperature increase of the display screen due to being heated on the back side thereof is solved. Therefore, the temperature increase rate of the display screen set close to a heat source is greatly reduced, when the equipment provided with the display screen is used.

Supports may also be set in the housing 20 to guarantee the structural strength of the housing.

Embodiment 2 of Display Device

FIG. 6 is a schematic structural view of a second embodiment of a display device according to the present invention. Referring to FIG. 6, a housing 25 is filled with vacuum fibers 26 or foamed plastics, and fastened to a back side of a display screen 11. As such, the amount of air in the housing 25 is greatly reduced, and the convection heat transfer is also reduced. Therefore, the thermal conductivity coefficient of the space within the housing 25 is effectively reduced, and the heat from the external environment is effectively prevented from being transferred to the display screen via the space within the housing 25 through convection heat transfer. The housing 25 may be shell-shaped, and surfaces of the housing 25 are appropriately designed in such a manner that the filler material does not leak out.

In the display devices mentioned in the above embodiments, an inner surface of the housing may be coated with a metal such as silver. With smooth surfaces of the metal such as silver, the heat transfer caused by heat radiation is effectively avoided. Thus, the thermal resistance between the external environment and the display screen is increased. Meanwhile, since a desirable heat-insulation effect is achieved through the above embodiments, the thickness of the housing (that is, a distance between the back side of the display screen and an outer surface of the housing) can be reduced to 0.5 mm. Therefore, the display device is greatly reduced in volume and becomes convenient to use and assemble.

In order to increase the user satisfaction of using electronic products, the present invention provides a heat dissipating device for an electronic product based upon user satisfaction through several embodiments, which includes a thermal-conductive housing surrounding a PCB and heating components. A user contact area on the thermal-conductive housing is enwrapped with heat-insulation structures adopted to reduce the surface temperature of some area. Moreover, the heat-insulation structures may be concave-convex structures formed on the user contact area of the thermal-conductive housing. Alternatively, the heat-insulation structures may be heat-insulation members laid on the user contact area of the thermal-conductive housing. The heat dissipating device according to the embodiments of the present invention may be directly used as a housing of an electronic product, and may also be used as a portion of the housing of the electronic product, which constitutes the housing of the electronic product together with a plastic housing.

The thermal-conductive housing is an article made of material having thermal conductivity coefficient over 15 W/m·K, which may be a thermal-conductive article made of a metal, for example, selected from copper, aluminum, iron, tin, lead, chromium, nickel, and silver; and may be a thermal-conductive article made of a non-metal material, for example, carbon fiber alloy and graphite. Moreover, the thermal-conductive housing is not limited to a single-layer structure, and may also be a composite thermal-conductive housing with a multilayer film structure formed by different thermal-conductive films through sticking or other manners. Generally, with a thermal-conductive housing having a thermal conductivity coefficient of over 15 W/m·K. an overall uniform temperature distribution can be achieved after the heat flow reaches the outer surface of the first thermal-conductive housing, and local hot spots can be eliminated. In order to enhance the heat transfer coefficient of the thermal-conductive housing made of metal and reduce the thermal resistance between the metal housing and the external air, surface treatment may be carried out, for example, surface anodic oxidation treatment for enhancing infrared heat transfer capability and electrical insulation treatment.

In the embodiments of the present invention, through the heat-insulation structures set on the user contact area of the thermal-conductive housing and adapted to reduce the surface temperature of the user contact area, a user's feeling about an excessively high surface temperature caused by heat dissipation when he/she touches the electronic product with the heat dissipating device as a housing or a portion of the housing is alleviated.

The above technical solutions of the present invention are described below in further detail through the accompanying drawings and specific embodiments.

FIG. 8 is a schematic structural view of a first embodiment of a heat dissipating device for an electronic product according to the present invention. Referring to FIG. 8, the heat dissipating device in this embodiment includes a thermal-conductive housing 20b set surrounding a PCB 10b and heating components 11b. A user contact area on the thermal-conductive housing 20b is formed with concave-convex structures 21b adapted to reduce the surface temperature of the area.

The concave-convex structures 21b may be configured into a trench structure with a surface geometry shape similar to that of a heat sink, and may also be configured into a structure with significant textures such as recess, bulge, groove, and rib. The above trench structure may have a circular arc-shaped, triangular, or rectangular section.

In this embodiment, the concave-convex structures 21b enlarge the heat-dissipation area between the heat generating device (electronic product) and the external air, and generate a certain temperature gradient, for example, the temperature inside the trench is relatively high and the temperature outside the trench is relatively low. When the interior of the trench is deep enough, the temperature outside the trench may be quite low, so as to increase the user satisfaction and avoid the user's complaints about heating.

In this embodiment, through forming the concave-convex structures 21b on the user contact area of the thermal-conductive housing 20b, the heat-dissipation area between the electronic product and the external air is increased, thereby enhancing the heat transfer capability between the electronic product and the external environment.

FIG. 9 is a schematic structural view of a second embodiment of a heat dissipating device for an electronic product according to the present invention. Referring to FIG. 9, in order to further enhance the heat transfer capability between the electronic product and the external environment, based on the first embodiment, air vents 22b are further opened on the thermal-conductive housing 20b to allow air circulation. The air vents 22b may be opened on the thermal-conductive housing 20b in pairs. In addition, corresponding air vents 22b may be opened on the PCB 10b to facilitate an effective air circulation.

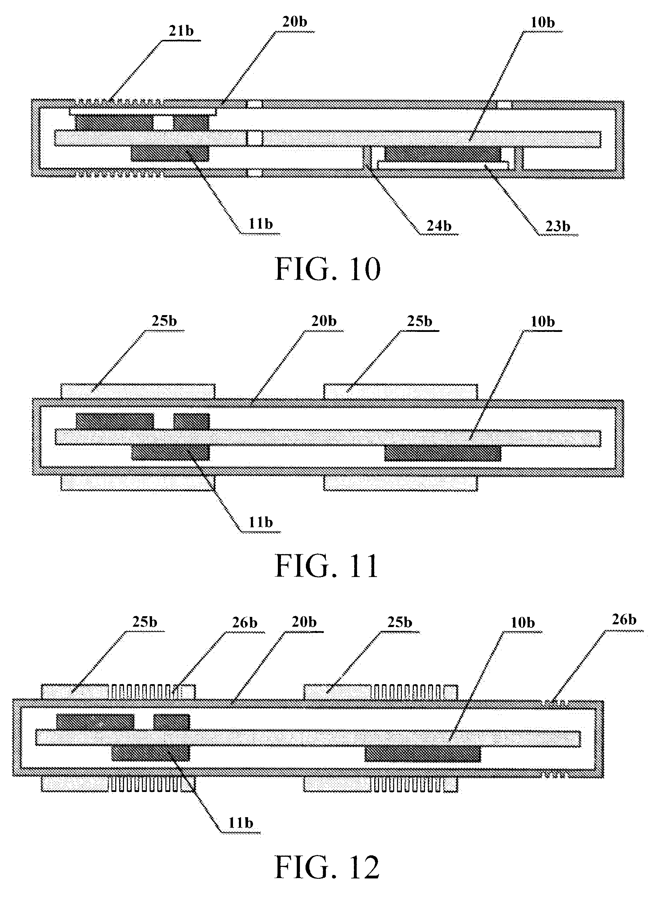

FIG. 10 is a schematic structural view of a third embodiment of a heat dissipating device for an electronic product according to the present invention. Referring to FIG. 10, in order to improve the surface temperature distribution of the electronic product, based on the first and second embodiments, a thermal-conductive pad 23b is set within the thermal-conductive housing 20b. One surface of the thermal-conductive pad 23b is connected to the inner surface of the thermal-conductive housing 20b, and the other surface is connected to the heat generating components 11b. For example, if the temperature of one surface of the thermal-conductive housing is lower than that of the other surface, the thermal-conductive pad 23b may be additionally set between the surface with a lower temperature and the heat generating components 11b to improve the surface temperature distribution of the electronic product. The thermal-conductive pad 23b may be made of a silica gel. In addition, a thermal-conductive filler material may also be set (not shown).

In this embodiment, thermal-conductive reinforced ribs 24b may be set within the thermal-conductive housing 20b. The thermal-conductive reinforced ribs 24b are connected to the PCB 10b close to the heating components 11b and directly absorb the heat from the high-temperature PCB close to the heating components.

FIG. 11 is a schematic structural view of a fourth embodiment of a heat dissipating device for an electronic product according to the present invention. Referring to FIG. 11, the heat dissipating device in this embodiment includes a thermal-conductive housing 20b set surrounding a PCB 10b and heat-generating components 11b. A user contact area on the thermal-conductive housing 20b is laid with heat-insulation members 25b adopted to reduce the surface temperature of some area. The heat-insulation members 25b are made of material with a thermal conductivity coefficient of smaller than 15 W/m·K. Generally speaking, the heat-insulation members 25b may be made of material with a thermal conductivity coefficient about 0.4 W/m·K such as plastic or rubber, material with a heat conductivity coefficient of 10 W/m·K, 6 W/m·K, or 110 W/m·K.

In this embodiment, through the heat-insulation members 25b laid on the user contact area of the thermal-conductive housing 20b, the surface temperature of the area is reduced, and the user's feeling about an excessively high surface temperature caused by heat transfer when he/she touches the electronic product is thus alleviated.

FIG. 12 is a schematic structural view of a fifth embodiment of a heat dissipating device for an electronic product according to the present invention. Referring to FIG. 12, in order to enhance the heat transfer capability between the electronic product and the external environment, based on the fourth embodiment, the surfaces of the thermal-conductive housing 20b and/or the heat-insulation members 25b are provided with trenches 26b. The above trenches may have circular arc-shaped, triangular, or rectangular sections.

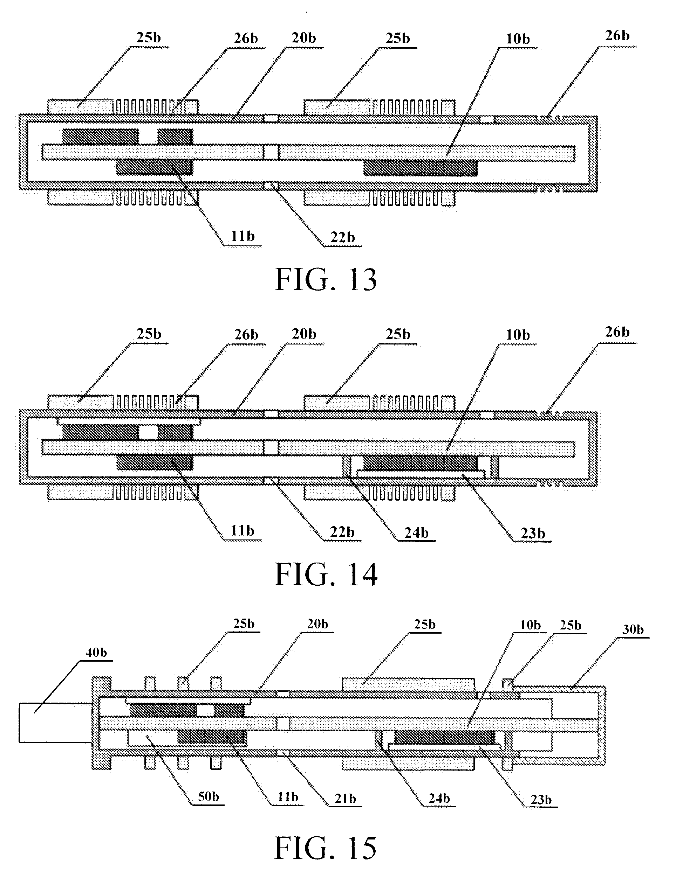

FIG. 13 is a schematic structural view of a sixth embodiment of a heat dissipating device for an electronic product according to the present invention. Referring to FIG. 13, in order to further enhance the heat transfer capability between the electronic product and the external environment, based on the fourth and fifth embodiments, air vents 22b may be opened on the thermal-conductive housing 20b to allow air circulation. The air vents 22b may be opened on the thermal-conductive housing 20b in pairs. In addition, corresponding air vents 22b may be opened on the PCB 10b to facilitate an effective air circulation.

FIG. 14 is a schematic structural view of a seventh embodiment of a heat dissipating device for an electronic product according to the present invention. Referring to FIG. 14, in order to improve the surface temperature distribution of the electronic product, based on the fourth embodiment, the fifth embodiment, and the sixth embodiment, a thermal-conductive pad 23b is further set within the thermal-conductive housing 20b. One surface of the thermal-conductive pad 23b is connected to the inner surface of the thermal-conductive housing 20b, and the other surface is connected to the heating components 11b. For example, when the temperature of one surface of the thermal-conductive housing is lower than that of the other surface, the thermal-conductive pad 23b may be additionally set between the surface with a lower temperature and the heat-generating components 11b to improve the surface temperature distribution of the electronic product. The thermal-conductive pad 23b may be made of a silica gel. In addition, a thermal-conductive filler material may also be set (not shown).

In this embodiment, thermal-conductive reinforced ribs 24b may be set within the thermal-conductive housing 20b. The thermal-conductive reinforced ribs 24b are connected to the PCB 10b close to the heating components 11b and directly absorb the heat from the high-temperature PCB close to the heat-generating components.

FIG. 15 is a schematic view of an application example of the above embodiments of the present invention. The application example is a high-density electronic product with natural heat dissipation. The electronic product includes a thermal-conductive housing 20b set surrounding a PCB 10b and heating components 11b. A user contact area on the thermal-conductive housing 20b is laid with heat-insulation members 25b adapted to reduce the surface temperature of some area. The surfaces of the thermal-conductive housing 20b and/or the heat-insulation members 25b are provided with trenches (not shown). The above trenches may have circular arc-shaped, triangular, or rectangular sections. Air vents 22b may be opened on the thermal-conductive housing 20b to allow air circulation. The air vents 22b may be opened on the thermal-conductive housing 20b in pairs. In addition, corresponding air vents 22b may be opened on the PCB 10b to facilitate an effective air circulation. Furthermore, a thermal-conductive pad 23b is set within the thermal-conductive housing 20b. One surface of the thermal-conductive pad 23b is connected to the inner surface of the thermal-conductive housing 20b, and the other surface is connected to the heat-generating components 11b. The thermal-conductive pad 23b may be made of a silica gel. In addition, a thermal-conductive filler material may also be set (not shown).

In this embodiment, thermal-conductive reinforced ribs 24b may also be set within the thermal-conductive housing 20b. The thermal-conductive reinforced ribs 24b are connected to the PCB 10b close to the heating components 11b and directly absorb the heat from the high-temperature PCB close to the heating components. 40b indicates a metal housing of a PCB plug, such as a metal plug on a USB stick of a USB disk or wireless modem. The thermal-conductive housing 20b is thermally connected to the metal housing 40b. The metal housing 40b is inserted into an electronic product such as a notebook, so that the heat of the USB disk or the wireless modem is transferred to the metal housing 40b via the thermal-conductive housing 20b and then transferred to the notebook via the metal housing 40b. Since the notebook has a desirable heat transfer performance, it assists the heat transfer of the electronic product or heating components wrapped by the thermal-conductive housing 20b, thereby greatly improving the heat dissipation function of the electronic product. The metal housing 40b and the thermal-conductive housing 20b enable the surface temperature distribution of the product to become more uniform, which are mainly applicable to products such as stick data cards and USB modems.

When the heat dissipating device for an electronic product based upon user satisfaction according to the above embodiments of the present invention is applied to the high-density electronic product with natural heat dissipation, the heat transfer capability between the electronic product with natural heat transfer and the external environment is effectively enhanced and the heat transfer bottleneck is alleviated. Thus, the requirements for reliability of the heating components are met, and meanwhile, the problem about the non-uniform surface temperature distribution of the electronic product is solved, thereby reducing hot-spot temperatures, increasing the user satisfaction, and avoiding the complaints about heating. In addition, the heat dissipating device for an electronic product according to the above embodiments of the present invention is suitable for flexible profile designs, easily implemented, and also enhances the core competition power of the electronic product.

The above embodiments are merely intended to describe the technical solutions of the present invention, but not to limit the scope of present invention. It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A mobile terminal for preventing temperature increase of a user-sensitive surface, comprising a user-sensitive surface and a Printed Circuit Board (PCB), wherein a heat-insulation layer is located between the user-sensitive surface and the PCB.

2. The mobile terminal according to claim 1, wherein the heat-insulation layer is an enclosed space in a vacuum state.

3. The mobile terminal according to claim 2, wherein at least one support is set in the enclosed space.

4. The mobile terminal according to claim 1, wherein the heat-insulation layer is filled with vacuum fibers or foamed plastics.

5. The mobile terminal according to any one of claims 1 to 4, wherein a metal is coated around the heat-insulation layer.

6. The mobile terminal according to any one of claims 1 to 4, wherein a distance between the user-sensitive surface and the PCB is 0.5 mm-3 mm.

7. A display device, comprising: a display screen, wherein a heat-insulation housing is located on the back side of the display screen.

8. The display device according to claim 7, wherein an interior of the heat-insulation housing is in a vacuum state.

9. The display device according to claim 8, wherein at least one support is set in the heat-insulation housing.

10. The display device according to claim 7, wherein the heat-insulation housing is filled with vacuum fibers or foamed plastics.

11. The display device according to any one of claims 7 to 10, wherein an inner surface of the heat-insulation housing is coated with metal.

12. A heat dissipating device for an electronic product based upon user satisfaction, comprising a thermal-conductive housing surrounding a Printed Circuit Board (PCB) and heating components, wherein a user contact area on the thermal-conductive housing is set with heat-insulation structure adapted to reduce a surface temperature of the user contact area.

13. The heat dissipating device according to claim 12, wherein the heat-insulation structures are concave-convex structures formed on the user contact area of the thermal-conductive housing.

14. The heat dissipating device according to claim 12, wherein the heat-insulation structures are heat-insulation members laid on the user contact area of the thermal-conductive housing.

15. The heat dissipating device according to claim 14, wherein the heat-insulation members have a thermal conductivity coefficient of lower than 15 W/m·K.

16. The heat dissipating device according to claim 14 or 15, wherein the thermal-conductive housing and/or the heat-insulation members are provided with trenches on surfaces of the thermal-conductive housing and/or the heat-insulation members.

17. The heat dissipating device according to any one of claims 12 to 16, wherein air vents are opened on the thermal-conductive housing.

18. The heat dissipating device according to any one of claims 12 to 16, wherein a thermal-conductive pad and/or thermal-conductive filler material is set within the thermal-conductive housing, and one surface of the thermal-conductive pad and/or thermal-conductive filler material is connected to an inner surface of the thermal-conductive housing, and the other surface of the thermal-conductive pad and/or thermal-conductive filler material is connected to the heating components.

19. The heat dissipating device according to any one of claims 12 to 16, wherein thermal-conductive reinforced ribs are set within the thermal-conductive housing, and the thermal-conductive reinforced ribs are thermally connected to the PCB.

20. The heat dissipating device according to any one of claims 12 to 16, wherein the PCB or the heating components are connected to a plug, and a metal housing of the plug is connected to the thermal-conductive housing.
